Europäisches Patentamt

European Patent Office

Office européen des brevets

(19)

(11) **EP 0 462 391 B1**

(12) **EUROPEAN PATENT SPECIFICATION**

(45) Date of publication and mention
of the grant of the patent:
**06.10.1999 Bulletin 1999/40**

(51) Int Cl.⁶: **G03F 7/038**, G03F 7/029

(21) Application number: **91107484.7**

(22) Date of filing: **08.05.1991**

(54) **Acid hardened photoresists**

Säuregehärtete Photoresiste

Photoréserves durcies par les acides

(84) Designated Contracting States:
**DE FR GB IT NL**

(30) Priority: **19.06.1990 US 540116**

(43) Date of publication of application:
**27.12.1991 Bulletin 1991/52**

(73) Proprietor: **SHIPLEY COMPANY INC.**
**Newton, Massachusetts 02162 (US)**

(72) Inventors:
• **Thackeray, James W.**
**Braintree, Massachusetts 02184 (US)**
• **Orsula, George W.**
**Tewksbury, Massachusetts 01876 (US)**
• **Canistro, Dianne**
**Lancaster, Massachusetts 01523 (US)**
• **McIlnay, Susan E.**
**Exton, Pennsylvania 19341 (US)**

(74) Representative: **Leiser, Gottfried, Dipl.-Ing. et al**
**Prinz & Partner GbR**
**Manzingerweg 7**
**81241 München (DE)**

(56) References cited:
**EP-A- 0 232 972          EP-A- 0 404 499**
**DE-A- 1 447 913**

**Description**

1. Introduction

This invention relates to use of a negative-acting, acid hardenable, deep UV photoresist comprising a phenolic resin having ring bonded hydroxyl sites, a thermally activated crosslinking agent that is an etherified aminoplast and a photoacid generator. More particularly, this invention relates to a negative-acting, deep UV photoresist where properties such as optical absorbance, dissolution rate, photospeed, contrast, resolution and sidewall angle are improved through the molar ratio of ring bonded hydroxyl groups of the phenolic resin to ether groups of the etherified aminoplast.

2. Description of the Prior Art

Photoresists are photosensitive films used for transfer of an image to a substrate. They may be negative or positive acting. After a coating of a photoresist is formed on a substrate, the coating is selectively exposed through a photomask to a source of activating energy such as ultraviolet light. The photomask has areas that are opaque to activating radiation and other areas that are transparent to activating radiation. The pattern in the photomask of opaque and transparent areas define a desired image to be transferred to a substrate.

In the case of a negative acting photoresist, exposed portions of a photoresist coating become less soluble in a developer as the result of a photochemical reaction, thereby resulting in differential solubility between the exposed and unexposed portions of the photoresist coating. This difference in solubility allows for the selective removal of unexposed portions of the photoresist coating and the subsequent transfer of an image to a substrate. Positive acting photoresists act in the opposite manner whereby exposed portions of the photoresist coating become more soluble in developer than the unexposed portions as the result of a photochemical reaction allowing for selective removal of exposed areas by development.

Following development of a photoresist coating, portions of the substrate bared by development may be altered such as by etching. The historical background, types and processing of conventional photoresists are described by DeForest, Photoresist Materials and Processes, McGraw-Hill Book Company, New York, Chapter 2, 1975 and by Moreau, Semiconductor Lithography, Principles, Practices and Materials, Plenum Press, New York, Chapters 2 and 4, 1988, both incorporated herein for their teaching of photoresist compositions and methods for making and using the same.

Most commercial photoresist formulations, both positive and negative, comprise a film forming binder and a light sensitive component or components. Many of these film forming binders are phenolic resins. For example, most positive acting photoresists in current commercial use comprise a novolak resin and a naphthoquinone diazide sulfonic acid ester photoactive compound where the novolak resin is the reaction product of formaldehyde and a phenol. Examples of such photoresists are disclosed in U.S. Patents Nos. 4,377,631 and 4,404,272. Another class of positive acting photoresists comprise a polyvinyl phenol and a naphthoquinone diazide sulfonic acid ester. Examples of these photoresists are disclosed in U.S. Patents Nos. 3,869,292 and 4,439,516.

Many negative acting photoresists also utilize phenolic resins as the film forming component of the photoresist. One such photoresist forms a negative image by image reversal. Photoresists capable of image reversal are positive acting photoresists, such as those described above, to which an image reversal agent, such as hexamethylolmelamine hexamethyl ether is added. Such a photoresist is disclosed in U.S. Patent No. 4,581,321. Other negative acting photoresists employing a phenolic binder are disclosed in EP-A-0 232 972 and EP-A-0 404 499, the latter one being post-published. The photoresists disclosed therein use a photoacid generator sensitive to selective wavelengths of activating energy including deep U.V., an aminoplast as a cross linking agent, and a phenolic, acid hardening, polymeric binder. In the presence of activating radiation, the photoacid generator is cleaved generating a strongly acidic environment. Upon subsequent heating, the generated acid activates the crosslinking agent to form a base soluble negative image in an image pattern. An improvement to the photoresist disclosed in EP-A-0 232 972 is disclosed in post-published document EP-A-0 401 499.

In this latter application, improved resolution is obtained by use of the partially saturated phenolic resin used as the binder in the photoresist system.

Of the acid hardened photoresists disclosed in EP-A-0 164 248, those comprising a phenolic resin, an etherified aminoplast cross linking agent and a photoacid generator are commercially available in the marketplace. One such commercial formulation is disclosed by Thackeray, J.W.; Orsula, G.W.; Pavelchek, E.K.; Canistro, D.; Bogan, Jr., L.E.; Berry, A.K.; Graziano, K.A.; Proc. SPIE, 1086, 34, (1989); and Thackeray, J.W.; Orsula, G.W.; Canistro, D.; Berry, A.K.; J. Photopolymer Sci. Tech., 2(3), 429 (1989), both incorporated herein by reference. One such acid hardening resist available in the marketplace is identified as MEGAPOSIT[R] SNR 248-1.0 photoresists available from Shipley company Inc. of Newton, Massachusetts. This photoresist exhibits high resolution capability with nearly vertical sidewalls in resist thicknesses up to 1.5 microns while retaining excellent plasma etch resistance. Notwithstanding the excellent properties of the commercially available acid hardening resists as described above, further improvements are always desired. For example, there is always a desire to reduce feature size, increase photospeed, improve the transparency of the optical path to permit increased film thickness, etc.

## Summary Of The Invention

The object of the invention is achieved by a method as set out in claim 1.

The subject invention provides processes for use of acid hardening photoresists comprising a phenolic resin, a photoacid generator and an etherified aminoplast crosslinking agent. The methods are characterized by provision of a photoresist where the concentrations of certain resist components relative to each other are correlated with processing conditions whereby improved photoresist properties are obtained making the photoresists suitable for new manufacturing applications. In particular, it has been found that control of the molar ratio of ring substituted hydroxyl groups on the phenolic polymer relative to the ether groups of the aminoplast crosslinking agent results in the subject acid hardening photoresists displaying improved properties such as enhanced optical absorbance of unexposed films, accelerated dissolution rate of unexposed films and improvements in imaging properties such as photospeed, contrast, resolution and sidewall angle which improvements permit new uses of the photoresist and new applications of the photoresist for the commercial manufacture of electronic devices.

For purposes of description herein, the term "chi ratio" has been adopted to define the molar ratio of ring substituted hydroxyl groups of the phenolic resin to ether groups of the aminoplast as follows:

$$\text{chi ratio} = \frac{[\text{C-OH}]}{[\text{Ether}]}$$

In accordance with the invention, the chi ratio varies between about 1.0 and 20.0 with the specific chi ratio dependent upon the desired properties of the photoresist as will be more fully explained below.

## Description of the Drawings

In the Drawings,

Figure 1 is a graphical depiction of absorption properties for a photoresist of the invention as a function of the chi ratio for said resist;

Figure 2 is a graphical depiction of the dissolution rate for a photoresist of the invention as a function of the chi ratio for said resist;

Figure 3 is a graphical depiction of the exposure energy required to expose the photoresist of the invention as a function of the chi ratio for said resist at two different temperatures;

Figure 4 is a graphical depiction of contrast of a photoresist resulting from exposure of a photoresist in accordance with Figure 3 of the drawings; and

Figures 5 to 9 of the drawings are photomicrographs of the cross section of a photoresist processed in accordance with the invention.

## Description Of The Preferred Embodiments

As described above, the invention comprises photoresists comprising a phenolic resin, a photoacid generator and an etherified aminoplast. The phenolic resin and the etherified aminoplast are used in concentrations and ratios to be more fully discussed below.

Phenolic resins used in photoresist manufacture are known in the art and typically comprise novolak and polyvinyl phenol resins. Such resins are disclosed in numerous publications including those cited above. Novolak resins are the thermoplastic condensation products of a phenol and an aldehyde. Examples of suitable phenols for condensation with an aldehyde, especially formaldehyde, for the formation of novolak resins include phenols; m-cresols; o-cresols; p-cresols; 2,4-xylenol; 2,5-xylenol; 3,4-xylenol; 3,5-xylenol and thymol. An acid catalyzed condensation reaction results in the formation of a suitable novolak resin which may vary in molecular weight from about 500 to 100,000 daltons. The preferred novolak resins conventionally used for the formation of photoresists are the cresol formaldehyde condensation products.

Polyvinyl phenol resins are thermoplastic polymers that may be formed by block polymerization, emulsion polymerization or solution polymerization of a corresponding monomer in the presence of a cationic catalyst. Vinyl phenols useful for the production of polyvinyl phenol resins may be prepared, for example, by hydrolysis of commercially available coumarin or substituted coumarins, followed by decarboxylation of the resulting hydroxy cinnamic acids.

Useful vinyl phenols may also be prepared by dehydration of the corresponding hydroxy alkyl phenols or by decarboxylation of hydroxy cinnamic acids resulting from the reaction of substituted or non-substituted hydroxybenzaldehydes with malonic acid. Preferred polyvinyl phenol resins prepared from such vinyl phenols have a molecular weight range of from about 2,000 to about 60,000 daltons.

Partially saturated phenolic resins such as those disclosed in EP-A-0 401 499, are also suitable for purposes of this invention. The partially saturated polyvinyl phenols may be formed by copolymerizing a cyclic alcohol with a phenol or preferably by hydrogenation of a preformed phenolic resin. By either method, the result is a copolymer having phenolic and cyclic alcohol repeating units where the ratio of phenolic units to cyclic alcohol units is dependent upon the number of cyclic alcohol groups copolymerized with the phenol or the number of conjugated bonds destroyed by hydrogenation.

One component of the photoresist of the invention is a photoacid generator, preferably of the type disclosed in EP-A-0 164 248. These photoacid generators include, for example, 1,1-bis[p-chlorophenyl]-2, 2,2-trichloroethane (DDT); 1,1-bis[p-methoxyphenyl]-2,2,2-trichloroethane (methoxychlor$^R$); 1,2,5,6,9,10-hexabromocyclododecane; 1,10-dibromodecane; 1,1-bis[p-chlorophenyl]-2,2-dichloroethane; 4,4'-dichloro-2-(trichloromethyl)benzhydrol or l,l-bis (chlorophenyl)2-2,2-trichloroethanol (Keltane$^R$); hexachlorodimethylsulfone; 2-chloro-6-(trichloromethyl)pyridine; 0,0-diethyl-0-(3,5,6,-trichloro-2-pyridyl)phosphorothioate (Dursban$^R$); 1,2,3,4,5,6-hexachlorocyclohexane; N(1,1-bis [p-chlorophenyl]-2,2,2-tri-chloroethylacetamide, tris[2,3-dibromopropyl]isocyanurate; 2,2-bis[p-chlorophenyl]-1,1-dichloroethylene.

The aminoplast component of the photoresist of the invention is one that contains one or more nitrogen groups and one or more ether groups having from one to four carbon atoms. Examples of aminoplasts are disclosed in the above cited EP-A-0 164 248. Of the aminoplasts disclosed in said application, those having hydroxyl groups reacted with an alkyl alcohol having from 1 to 4 carbon atoms to form ether linkages are suitable for purposes of this invention. Preferred materials are melamine and melamine formaldehyde resins which have been alkoxylated through a hydroxyl group. Most preferred materials are hexaalkoxymethylmelamines, especially those available from American Cyanamid Company such as Cymel 300, 301, 303, 350, 370, 380, 1116 and 1130. These materials are described, with their structural formulas, in a product brochure entitled "High Solids Amino Crosslinking Agents" furnished by American Cyanamid Company, incorporated herein by reference. Of the aminoplasts contemplated herein, hexamethoxymethylmelamine constitutes the most preferred embodiment of the invention.

The above described components of the acid hardened photoresist are used to form a photosensitive coating composition containing, for example, from 40 to 90 parts by weight of the reactive hydrogen containing resin, from 40 to 90 parts by weight of the aminoplast and from 2 to 30 parts by weight of the photoacid generator. The percentages set forth herein are based upon the total weight of solids portion of the composition.

The solids comprising the photoresist are dissolved in a suitable solvent to make a coating composition. Such solvents include one or more of the glycol ethers such as ethylene glycol monomethyl ether, ethylene glycol monoethyl ether and propylene glycol monoethyl ether; cellosolve esters such as methylcellosolve acetate, ethylcellosolve acetate and propylene glycol monomethyl ether acetate; aromatic hydrocarbons such as toluene and xylene; ketones such as methyl ethyl ketone, cyclopentanone and cyclohexanone; esters such as ethyl acetate, butyl acetate, isobutylisobuterate, ethyl lactate; amides such as dimethyl acetamide and dimethyl formamide; chlorinated hydrocarbons such as ethylene dichloride, chlorobenzene and ortho-dichlorobenzene; nitrobenzene; etc. The photosensitive composition in the form of a liquid coating composition may, for example, contain at least 50 weight percent of the total composition and preferably comprises from 65 to 95 percent by weight of the total composition.

Other additives may be incorporated into the photosensitive coating composition in minor amounts such as from about 0.001 percent to about 10 percent by weight based upon total solids to enhance the performance of the coating composition and the resulting dried coating. These additives can function as flow and leveling agents, anti-striation agents, plasticizers, anti-reflecting dyes, etc. Other materials which may be present as is known in the art and taught in the aforesaid EPO published application No. 0 164 248.

In accordance with the subject invention, properties of an acid hardened photoresist are capable of optimization by control of the chi ratio, as defined above. For purposes of this invention, the chi ratio may vary between about 1.0 and 20.0. The specific chi ratio for a given photoresist property will vary within this broad range and will depend upon the particular property to be controlled. Further, with respect to certain of the properties to be controlled in accordance with the invention, the selection of the chi ratio will depend upon the cure temperature used to process an exposed image in a dry coating. Cure temperatures in accordance with the invention may vary between about 70ºC and 160ºC. As would be understood by those in the art, cure time is dependent upon the desired properties of the photoresist and the temperature.

Processes for use of the photoresists of the invention include the following steps:

a. provide an acid hardening photoresist composition comprising a phenolic resin, an aminoplast and a photoacid generator where the photoresist has a chi ratio selected to provide a developed image having a desired property;

b. coat the photoresist onto a substrate and dry the same;

c. expose the photoresist to activating radiation;

d. bake the photoresist to induce crosslinking within a temperature range of from about 70 to about 160ºC with temperature correlated with chi ratio to provide the desired property as necessary; and

e. develop the imaged photoresist with a suitable developer to provide an imaged coating.

The above steps will be described in greater detail below.

The step of coating the photoresist onto a substrate and drying the same is in accordance with prior art procedures. For example, the photoresist may be applied by spin coating, roller coating, or any other method known to the art. Substrates over which the photoresist may be coated include silicon or silicon dioxide wafers such as those used in the production of microprocessors and other miniaturized integrated circuit components. Aluminum/aluminum oxide and silicon nitride wafers can also be coated using the photosensitive composition of the invention resulting in excellent film adhesion. The step of drying is conventional and comprises baking to remove substantially all residual solvents forming a tack free coating. Baking the substrate over which the photoresist coating has been applied at about 70ºC to about 110ºC from about several up to about thirty minutes has been found to be satisfactory to dry the film. Alternative methods such as hot plate heating, with shorter bake times and higher temperatures, can also provide suitable results.

After the photoresist is dried on its substrate, the photoresist is exposed by conventional techniques to actinic activating radiation through a photomask to provide a latent image in the photoresist coating as set forth in step c. Imaging can take place at wavelengths varying from 190 nm to 365 nm. Other energy sources may also be used such as x-ray and electron beam.

Following exposure of the photoresist coating to activating radiation, the photoresist is baked to induce crosslinking in light exposed areas. In accordance with the invention, and as more fully described below, for certain applications, the selection of bake temperature is dependent upon desired resist properties and is correlated with the chi ratio. The full range of bake temperatures in accordance with the invention may vary between about 70ºC and 160ºC. The time of bake within this temperature range may vary from as few as 10 seconds up to several minutes or more.

Following baking of the resist, the resist film is developed. Typical developers for the resist of the invention include aqueous solutions of inorganic alkalis such as sodium hydroxide, potassium hydroxide, sodium carbonate, sodium bicarbonate, sodium silicate, sodium metasilicate or aqueous ammonia or aqueous solutions of organic alkalis such as primary amines including ethylamine or n-propyl amine, secondary amines such as diethylamine or di-n-propylamine; tertiary amines such as triethylamine or methyldiethylamine, alcohol amines such as dimethylethanolamine or triethanolamines, quaternary ammonium hydroxides such as tetramethylammonium hydroxide or tetraethylammonium hydroxide, etc. Such developers are well known in the art.

In accordance with the invention, the photoresist may be tailored to meet specific application requirements by control of the chi ratio - the molar ratio of ring substituted hydroxyl groups on the phenolic resin to ether groups on the etherified aminoplast, and in some cases, correlating this ratio with cure temperature. Properties that can be controlled in this manner include optical absorption, dissolution rate and photolithographic properties such as photospeed, contrast, resolution and sidewall angle.

The discussion that follows illustrates how control of the properties enumerated above permits the photoresists of the invention to be formulated for specific applications.

Optical Absorption

Absorption of activating radiation by a photoresist coating is an important property that affects the utility of the photoresist. For example, a photoresist coating that minimally absorbs activating radiation enables the photoresist to be applied as a thick film because the activating radiation is capable of penetrating the full thickness of the film exposing the photoresist coating down to the substrate. This permits crosslinking of the photoresist down to the substrate resulting in an image of good resolution in thick cross section. This is desirable for applications where thick films are needed such as where rigorous processing conditions are used, for example in such as plasma etching where the photoresist is eroded during the plasma etch.

Also, thicker films are required where severe topography is present on the substrate. For example, if 0.5 micron or greater in height structures are present on a substrate, it is necessary to use photoresists at thicknesses of 1.0 micron or greater to cover the structures.

A photoresist coating that is highly absorptive of activating radiation is also desirable for many applications. Photoresists that are highly absorptive are suitable where thin films and high resolution are required. The absorption of activating radiation by the photoresist coating restricts reflection of activating radiation from the substrate surface which causes undesired exposure of the photoresist and loss of image resolution. In the prior art, it is customary to add an absorbing dye to a photoresist to inhibit reflection. However, it is also known in the art that it is desirable to maintain the number of additives in the composition to a minimum as each additive may deleteriously interfere with the performance of the photoresist. For example, dyes may be unstable leading to particle formation in the resist and further, they compete with the light sensitive components of the photoresist for the activating energy thereby often decreasing the photo properties of the photoresist.

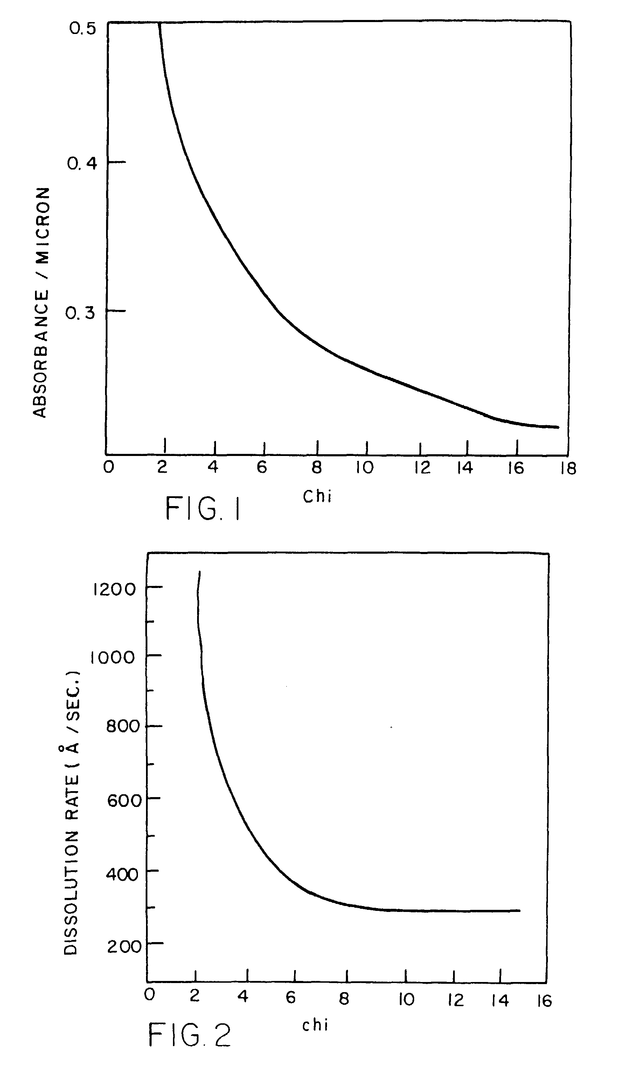

In accordance with the subject invention, it has been found that through adjustment of the chi ratio, it is possible to formulate a resist having optical absorption properties varying from those of a dyed resist to one that is essentially optically transparent. The relationship between the chi ratio and transparency is shown in Figure 1 of the drawings which graphically depicts the absorption of a photoresist per micron of thickness as a function of the chi ratio. The results illustrated in Figure 1 are taken from Example 1 below.

From Figure 1 of the drawings, it can be seen that optical absorbance asymptotically approaches that of the phenolic resin portion of the resist as chi ratio increases to a maximum of about 15. However, as chi ratio decreases towards a minimum of about 1, absorbance increases dramatically. At the lower chi ratios, the absorbance of the photoresist is essentially equivalent to a photoresist containing a highly absorptive dye.

From the above discussion, one embodiment of the invention is provision of a photoresist composition that minimally absorbs activating radiation and is suitable for formation of thick photoresist coatings - i.e., photoresists having a dried coating thickness of at least 0.5 microns and preferably ranging between 1.0 and 2.0 microns. These photoresists comprise formulations of the type contemplated herein where the chi ratio varies within a range of from 6.0 to 18.0 and preferably within a range of from 6.0 to 12.0.

Dissolution Rate Enhancement

The development properties of a photoresist are a commercially significant property as it governs the rate at which an electronic device can be processed through a processing line - i.e., the throughput. In commercial processing, it is desirable that throughput be as rapid as possible without sacrifice of image resolution. The shorter the development time of a patterned wafer, the greater number of patterned wafers that can be processed per hour. For example, if it takes 120 seconds to develop one wafer, only 30 wafers per hour can be processed. If it takes 30 seconds to develop one wafer, 120 wafers per hour can be processed.

In accordance with the invention, it has been found that by adjustment of the chi ratio within a range of from 1.0 to 8.0 and preferably within a range of from 1.5 to 5.0, there is adequate etherified aminoplast available for crosslinking providing images of excellent resolution and a rate of development that exceeds that of the phenolic resin binder. In this manner, dissolution rate enhancement of the resist film will shorten development times at these chi ratios. This is shown in Figure 2 of the drawings which is a graphical representation of dissolution rate in angstroms per second as a function of chi ratio and depicts the results obtained in Example 2 below. It can be seen from the drawing that dissolution rate asymptotically approaches that of the phenolic resin above a chi ratio of 8.0.

Photolithographic Properties

The photospeed of a photoresist is a measure of the energy required to expose a photoresist to obtain a latent image capable of crosslinking through its full coating thickness. A photoresist that requires a minimum exposure dose to expose the full thickness of the film is considered fast and desirable because processing time of devices is reduced. In practice, it is often found that enhanced photospeed is often at the expense of contrast or image resolution. In other words, optimizing the photospeed of a photoresist often results in a reduction in the resolution of a developed image.

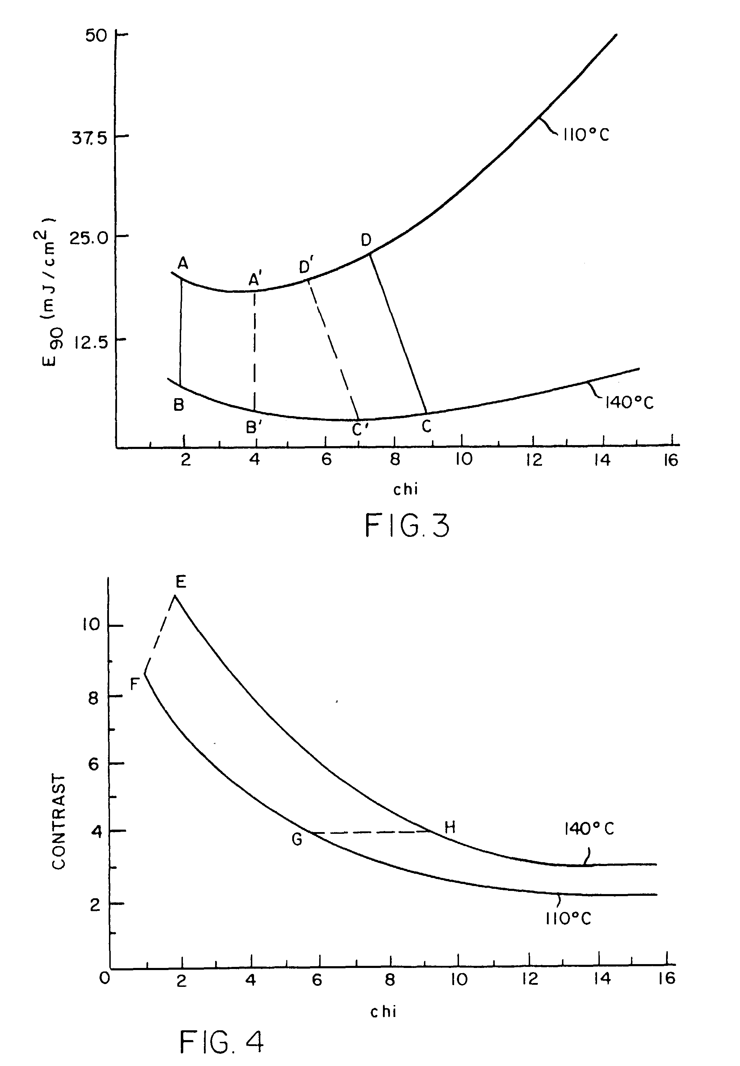

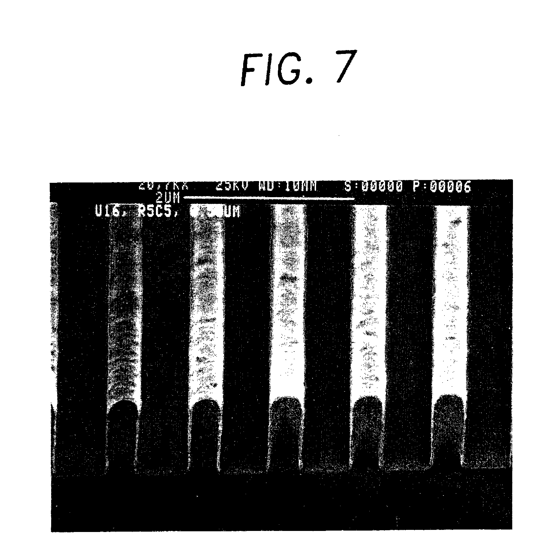

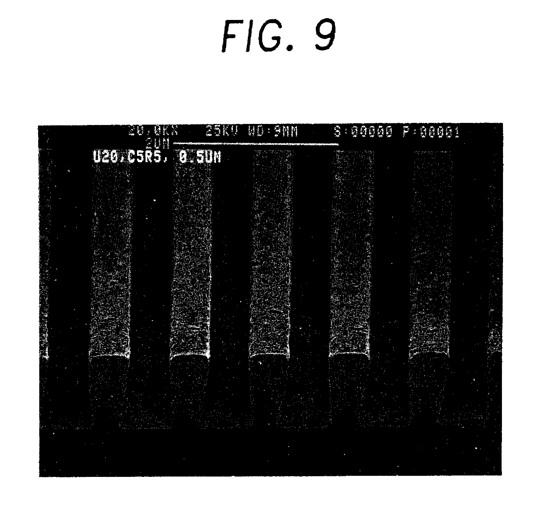

Again, throughput is optimized when using the fastest photospeed possible to print an image. Figure 3 shows that at 110ºC post-exposure bake, fastest photospeed is obtained at chi ratios of 2 to 5. At 140ºC post-exposure bake, fastest photospeed is obtained at chi ratios of 3 to 10. These optimized chi ratios will allow the exposure time to be shortened, thereby increasing the number of wafers per hour produced. Results shown in Figures 7 and 9 show that high resolution is still achievable with these optimized chi ratios.

In accordance with the subject invention, by control of the chi ratio and cure temperature following exposure, photospeed is significantly increased while contrast is improved. This can be seen from Figures 3 and 4 of the drawings. Figure 3 graphically depicts energy in millijoules per square centimeter at two different cure temperatures where energy is defined as that necessary to retain 90 percent of the original film thickness as a function of chi.

Figure 4 is a graphical representation of contrast of a developed film as a function of chi at the same cure temperatures. With respect to Figure 4, to calculate contrast, the linear portion of the curve is extrapolated to 0 and 1.0 normalized thickness, at exposures of $E_0$ and $E_1$, respectively. Contrast is defined as $1/\log(E_1/E_0)$. The graph depicts contrast at varying chi ratios using photoresists cured at 110ºC and 140ºC, respectively. To select an operating range for the chi ratio, a minimum contrast of 4.0 was selected as defined by the area EFGH. High contrast is obtained by operating in this region on the curves.

Using this criterion to define contrast, it is possible to define a region depicted as ABCD in Figure 3 where the exposure dose is at a minimum but is adequate to provide the desired contrast. The preferred region is defined in Figure 3 and depicted as A'B'C'D'. This area corresponds to the area of maximum lithographic crosslinking efficiency (chi max). Chi max is defined as those chi ratio(s) at which the lowest dose is required to induce a given amount of crosslinking, as well as the steepest response to a dose gradient (i.e. highest contrast).

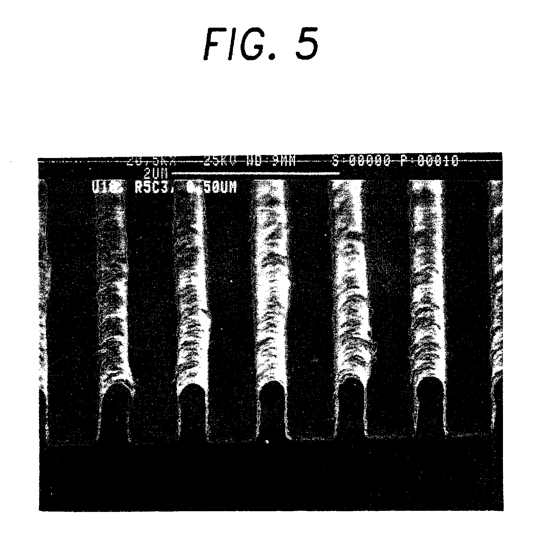

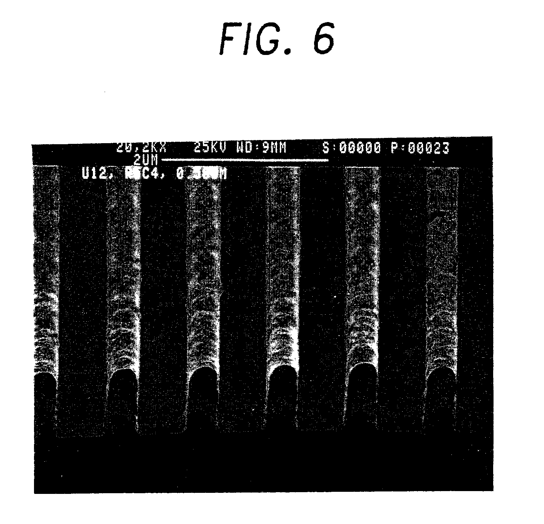

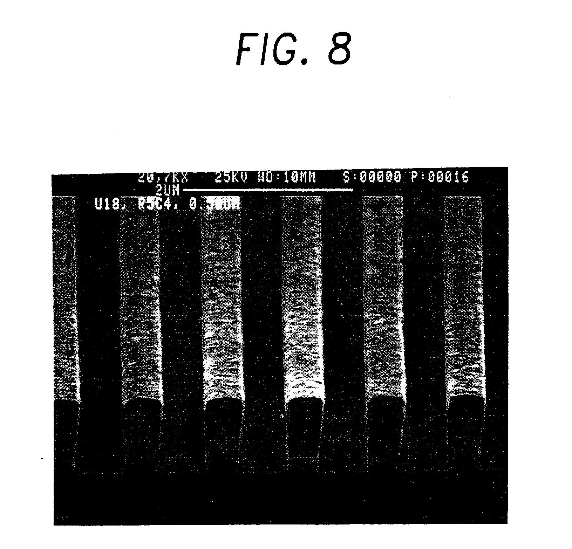

Improvements in contrast of the photoresist having the desired chi ratios are shown in Figures 5 through 9 which are photomicrographs of a silicon wafer coated with photoresist having a thickness of approximately 1 micron. The photoresists were exposed through a 0.5 micron grating and cured at a temperature of 110°C for 60 seconds. The chi ratio used for each photoresist is as follows:

|          | Chi Ratio |
|----------|-----------|
| Figure 5 | 14.4      |
| Figure 6 | 10.8      |
| Figure 7 | 7.2       |
| Figure 8 | 2.4       |
| Figure 9 | 1.8       |

From Figures 5 to 9, it is seen that the sidewall angle goes from 87° positive to 95° re-entrant as chi goes from 14.4 to 1.8. Also, the tops of the lines are less rounded at the lower chi values with less bridging residues.

The invention will be better understood by reference to the examples which follow.

Example 1

Five resists of varying chi ratio were formulated according to the following table:

Table I

| Resist | Chi Ratio | PVP (g) | PAG (g) | HMMM (g) | Diglyme (g) |
|--------|-----------|---------|---------|----------|-------------|
| 1      | 14.4      | 10      | 0.5     | 0.375    | 28.8        |
| 2      | 10.8      | 10      | 0.5     | 0.50     | 28.8        |
| 3      | 7.2       | 10      | 0.5     | 0.75     | 28.8        |
| 4      | 2.1       | 10      | 0.5     | 2.25     | 28.8        |
| 5      | 1.8       | 10      | 0.5     | 3.00     | 28.8        |

In this example, PVP is PHM-c grade poly-p-vinyl phenol as supplied by Maruzen chemical, PAG (photoacid generator) is tris-(2,3-dibromopropyl) isocyanate, HMMM is hexamethoxymethylmelamine, and diglyme is diethylene glycol dimethyl ether. The resists were all coated onto 7.62 cm (3 inch) quartz wafers to a 1 micron thickness using standard spin coating techniques. The coated wafers were baked at 90°C for 30 minutes in a convection oven. The absorbance of each coated wafer was measured at 248 nm with an HP 8452A Spectrophotometer.

Figure 1 shows the absorbance per micron as a function of the chi ratio. The absorbancy of HMMM leads to increased absorbancy at the low chi ratios.

Example 2

This example shows that the rate of dissolution of unexposed resist films increases as the chi ratio decreases. The five resist solutions of Example 1 were spin coated and softbaked using the procedure of Example 1 but using 4 inch silicon wafers as the substrate in order to permit measurement of the film thickness by laser interferometry.

After softbaking and cooling to ambient temperature, the coatings were dissolved in an aqueous alkaline developer (Shipley[R] Microposit MF312-CD14 developer) at 25°C. The thickness of the coating was measure initially with a Nanospec/AFT instrument. During development the thickness of the coating was monitored with a helium/neon laser interferometer by means of a fiber optic probe immersed in the developer, permitting measurement of the time to clear. The time to clear is defined as the exact time it takes to develop the full thickness of the unexposed resist. The average rate of dissolution was calculated from the initial thickness of the coating and the time required for complete removal. Average values of four replicate measurements with each resist solution are plotted in Figure 2 of the drawings.

The results demonstrate that dissolution rate increases dramatically below chi ratios of 8.0. In this manner, an unexpected advantage is that development time can be shortened at low chi ratios.

Example 3

The solutions of Example 1 were spin coated onto bare silicon wafers (vapor primed with HMDS for 5 minutes) at 4000 rpm for 30 seconds, then softbaked at 90°C for 60 seconds on a vacuum hotplate, yielding a film of approximately 1 micron thickness. An array of 7 by 7 mm square regions ("pads") was exposed over a range of exposure energies from 4 to 124 mJ/cm$^2$, in steps of 4 mJ/cm$^2$, using a GCA AWIS excimer laser stepper at a wavelength of 248 nm. The coated wafers were then baked ("post-exposure bake") at 110°C for 60 seconds on a vacuum hotplate to bring about an acid catalyzed crosslinking reaction, or at 140°C for 60 seconds. The resist was then developed by immersion in Microposit$^R$ MF-312 developer at a concentration of 0.14N at six times the normal time to clear the unexposed resist. After rinsing and drying, the thickness of each pad was measured with a Nanospec/AFT as in Example 2, basing the calculations on a photoresist refractive index of 1.64. The results are set forth in Figure 3 of the drawings in which the abscissa is given in dosage units of 0.4 mJ/cm$^2$

From the contrast curves for the various chi ratio resists, the photospeed and contrast of the photoresist may be calculated. For a negative photoresist system, photospeed is defined as the energy necessary to retain 90% of the original thickness. Contrast relates to the slope of the curve. To calculate contrast, the linear portion of the curve is extrapolated to 0 and 1.0 normalized thickness, at exposures of $E_o$ and $E_1$, respectively. The contrast is defined as I/$\log(E_1/E_o)$.

Based on the above procedure for determining contrast curves, Figure 3 showing photospeed versus chi ratio was generated, along with Figure 4 showing contrast versus chi ratio.

Example 4

The scanning electron micrographs as shown in Figures 5 through 9 were generated by the following procedure. Each photoresist solution of Example 1 with varying chi ratio was coated on silicon wafers, softbaked, exposed and post-exposure baked (110°C for 60 seconds) as described in the earlier examples. During exposure, a mask is placed in the GCA Laserstep excimer laser stepper so as to produce fine line and space grating patterns of 0.5 micron dimension. Each resist coated substrate was developed at six times the normal time to clear the unexposed resist. Each resist-coated substrate is then coated with 10 nm (100 Angstroms) of gold, cracked along the line/space grating then mounted in a Cambridge scanning electron microscope at a 75° angle to the substrate. The image is then magnified by 10,000X. These images are shown in Figures 5 through 9.

Figures 5 through 9 show unexpected advantages for submicron imaging of these resists when applied to actual products using criteria of the present invention. First, there is less rounding at the top of the resist at lower chi ratios. The rounding is a consequence of loss of photo generated acid (HBr) to the air during the post-exposure bake process. Applicant does not wish to be bound by theory, but it is believed that the unexpected result is due to the aminoplast component which holds the photo generated acid in the resist film when present in higher concentrations and prevents diffusion of the acid into the air. Another unexpected advantage is less edge roughness and less bridging residue as the chi ratio decreases. Again, this is believed to be due to the aminoplast holding the photo generated acid in the exposed areas and preventing diffusion into unexposed areas.

**Claims**

1.    A method for forming a photoresist image, said method comprising the steps of:

    a.) providing a photoresist solution comprising an admixture dissolved in a solvent of an acid hardening phenolic resin, an etherified aminoplast crosslinking agent having at least one alkoxy group per molecule in an amount sufficient to provide a developable latent image following exposure and a photoacid generator capable of liberating acid upon exposure to activating energy;

    b.) coating said photoresist on a substrate and substantially drying the so formed coating;

    c.) exposing the dried coating to patterned activating radiation;

    d.) curing the exposed photoresist at a cure temperature varying between about 70 and 160°C for a time sufficient to cure the photoresist; and

e.) developing the photoresist with a developer,

characterized in that controlling the molar ratio of ring substituted hydroxyl groups on the phenolic resin relative to the ether groups of the amino-plast crosslinking agent ("chi ratio") within a range of from 1.0 to 20.0. is used to selectively impart to said photoresist desired properties including improved optical absorption, dissolution rate, photospeed, contrast, resolution and sidewall angle.

2. The method of claim 1 where the photoresist composition minimally absorbs activating radiation and is suitable for formation of a photoresist image having a dried thickness of at least 0.5 microns, said ratio of the moles of ring substituted hydroxyl groups on the phenolic resin to the alkoxy groups of the aminoplast ranging between 6.0 and 18.0 and the photoresist is coated onto the substrate in a thickness whereby upon drying of the same, the dry coating thickness exceeds 0.5 microns.

3. The method of claim 2 wherein said ratio is between 6.0 and 12.0.

4. The method of claim 1 where reflection of activating radiation from a surface over which the photoresist is coated is reduced, said ratio of the moles of ring substituted hydroxyl groups on the phenolic resin to the alkoxy groups of the aminoplast ranging between 2.0 and 6.0.

5. The method of claim 4 wherein said ratio is between 2.0 and 4.0.

6. The method of claim 1 where the dissolution rate of the unexposed photoresist from a surface over which the photoresist is coated is enhanced, said ratio of the moles of ring substituted hydroxyl groups on the phenolic resin to the alkoxy groups of the aminoplast ranging between 1.0 and 8.0, and said cure temperature varies between about 90 and 150° C.

7. The method of claim 6 wherein said ratio is between 1.5 and 5.0.

8. The method of claim 1 where the photospeed is enhanced, said ratio of the moles of ring substituted hydroxyl groups on the phenolic resin to the alkoxy groups of the aminoplast ranging between 2 and 9, and said cure temperature varies between about 110° and 140°C.

9. The method of claim 8 wherein said ratio is between 4 and 7.

10. The method of claim 1 where a high contrast photoresist image is formed, said ratio of the moles of ring substituted hydroxyl groups on the phenolic resin to the alkoxy groups of the aminoplast ranging between 1 and 9, and said cure temperature varies between about 110° and 140°C.

11. The method of claim 1 where a high contrast photoresist image is formed while the diffusion coefficient of photo generated acid through the resist/air interface and through the unexposed/exposed resist interface is reduced, said ratio of the moles of ring substituted hydroxyl groups on the phenolic resin to the alkoxy groups of the aminoplast ranging between 1.0 and 8.0, and said cure temperature varies between about 70 and 160°C.

12. The method of claim 11 wherein said ratio is between 1.0 and 3.0.

13. The method of any one of claims 1 to 12 wherein said acid hardening phenolic resin is a novolak.

14. The method of claim 13 wherein said novolak is the product of a cresol formaldehyde condensation.

15. The method of any one of claims 1 to 12 wherein said acid hardening phenolic resin is a polyvinylphenol.

16. The method of claim 15 wherein said polyvinylphenol is a partially saturated polyvinylphenol.

17. The method of any one of claims 1 to 16 wherein said aminoplast is an alkoxylated melamine.

18. The method of any one of claims 1 to 16 wherein said aminoplast is an alkoxylated melamine formaldehyde resin.

19. The method of claim 17 wherein said alkoxylated melamine is hexamethoxymethylmelamine.

20. The method of any one of claims 1 to 19 wherein said photoacid generator is chosen from the group consisting of 1,1-bis[p-chlorophenyl]2,2,2-trichloroethane (DDT); 1,1-bis[p-methoxyphenyl]2,2,2-trichloroethane (methoxychlor$^R$); 1,2,5,6,9,10-hexabromocyclododecane; 1,10-dibromodecane; 1,1-bis[p-chlorophenyl]2,2-dichloroethane; 4,4'-dichloro-2-(trichloromethyl)benzhydrol or 1,1-bis(chlorophenyl)2,2,2-trichloroethanol (Keltane$^R$); hexachlorodimethylsulfone; 2-chloro-6-(trichloromethyl)pyridine; O,O-diethyl-O-(3,5,6,-trichloro-2-pyridyl)phosphorothioate (Dursban$^R$); 1,2,3,4,5,6-hexachlorocyclohexane; N(1,1-bis[p-chlorophenyl]-2,2,2-tri-chloroethylacetamide, tris [2,3-dibromopropyl]- isocyanurate; 2,2-bis[p-chlorophenyl]-1,1-dichloroethylene.

21. The method of claim 20 wherein said photoacid generator is tris[2,3-dibromopropyl]isocyanurate.

## Patentansprüche

1. Verfahren zur Erzeugung eines Photoresistbildes, wobei das Verfahren die folgenden Schritte umfaßt:

   a) es wird eine Photoresistlösung bereitgestellt, die ein in einem Lösemittel gelöstes Gemisch umfaßt, welches aus einem säurehärtenden Phenolharz, einem verätherten Aminoplast mit mindestens einer Alkoxygruppe je Molekül als Vernetzer in einer Menge, die zur Erzeugung eines entwickelbaren latenten Bildes nach Belichtung ausreicht, und einer unter Lichteinwirkung Säure erzeugenden Verbindung besteht, die zur Freisetzung von Säure in der Lage ist, nachdem sie aktivierender Energie ausgesetzt worden ist;

   b) ein Substrat wird mit dem Photoresist beschichtet, und die so gebildete Beschichtung wird weitgehend getrocknet;

   c) die getrocknete Beschichtung wird bildmäßig aktivierender Strahlung ausgesetzt;

   d) der belichtete Photoresist wird bei einer Härtungstemperatur zwischen etwa 70 und 160°C während einer zur Härtung des Photoresists ausreichend langen Dauer gehärtet; und

   e) der Photoresist wird mit einem Entwickler entwickelt,

   dadurch gekennzeichnet, daß die Steuerung des molaren Verhältnisses zwischen ringsubstituierten Hydroxylgruppen am Phenolharz und den Äthergruppen des als Vernetzer eingesetzten Aminoplasten ("chi-Verhältnis") innerhalb eines Bereiches von 1,0 bis 20,0 dazu benutzt wird, um dem Photoresist selektiv gewünschte Eigenschaften zu verleihen, darunter eine verbesserte optische Absorption, eine verbesserte Auflösungsgeschwindigkeit, eine verbesserte Lichtempfindlichkeit, einen verbesserten Kontrast, eine verbesserte Auflösung und einen verbesserten Randwinkel.

2. Verfahren nach Anspruch 1, bei dem die Photoresist-Zusammensetzung aktivierende Strahlung nur minimal absorbiert und zur Erzeugung eines Photoresistbildes mit einer Dicke von mindestens 0,5 um im getrockneten Zustand geeignet ist, bei dem das Molverhältnis zwischen den ringsubstituierten Hydroxylgruppen am Phenolharz und den Alkoxygruppen des Aminoplasten im Bereich zwischen 6,0 und 18,0 liegt und das Substrat mit dem Photoresist in einer solchen Dicke beschichtet wird, daß nach dem Trocknen die Dicke der trockenen Beschichtung 0,5 um übersteigt.

3. Verfahren nach Anspruch 2, bei dem das Verhältnis zwischen 6,0 und 12,0 liegt.

4. Verfahren nach Anspruch 1, bei dem die Reflexion aktivierender Strahlung von einer Oberfläche, die mit dem Photoresist beschichtet ist, vermindert ist und das Molverhältnis zwischen ringsubstituierten Hydroxylgruppen am Phenolharz und den Alkoxygruppen des Aminoplasten zwischen 2,0 und 6,0 beträgt.

5. Verfahren nach Anspruch 4, bei dem das Verhältnis zwischen 2,0 und 4,0 beträgt.

6. Verfahren nach Anspruch 1, bei dem die Auflösungsgeschwindigkeit des unbelichteten Photoresists von einer Oberfläche, die mit dem Photoresist beschichtet ist, erhöht ist und das Molverhältnis zwischen ringsubstituierten Hydroxylgruppen am Phenolharz und den Alkoxygruppen des Aminoplasten zwischen 1,0 und 8,0 beträgt und die Härtungstemperatur zwischen etwa 90 und 150°C liegt.

EP 0 462 391 B1

**7.** Verfahren nach Anspruch 6, bei dem das Verhältnis zwischen 1,5 und 5,0 liegt.

**8.** Verfahren nach Anspruch 1, bei dem die Lichtempfindlichkeit erhöht ist und das Molverhältnis zwischen den ringsubstituierten Hydroxylgruppen am Phenolharz und den Alkoxygruppen des Aminoplasten zwischen 2 und 9 beträgt und die Härtungstemperatur zwischen etwa 110 und 140°C liegt.

**9.** Verfahren nach Anspruch 8, bei dem das Verhältnis zwischen 4 und 7 beträgt.

**10.** Verfahren nach Anspruch 1, bei dem ein kontrastreiches Photoresistbild erzeugt wird und das Molverhältnis zwischen den ringsubstituierten Hydroxylgruppen am Phenolharz und den Alkoxygruppen des Aminoplasten zwischen 1 und 9 beträgt und die Härtungstemperatur zwischen etwa 110 und 140°C liegt.

**11.** Verfahren nach Anspruch 1, bei dem ein kontrastreiches Photoresistbild erzeugt wird, während der Diffusionskoeffizient der unter Lichteinwirkung erzeugten Säure an der Grenzfläche zwischen Resist und Luft und an der Grenzfläche zwischen unbelichtetem und belichtetem Resist vermindert ist, bei dem das Molverhältnis zwischen den ringsubstituierten Hydroxylgruppen am Phenolharz und den Alkoxygruppen des Aminoplasten zwischen 1,0 und 8,0 beträgt und die Härtungstemperatur zwischen etwa 70 und 160°C liegt.

**12.** Verfahren nach Anspruch 11, bei dem das Verhältnis zwischen 1,0 und 3,0 beträgt.

**13.** Verfahren nach einem der Ansprüche 1 bis 12, bei dem das säurehärtende Phenolharz ein Novolak ist.

**14.** Verfahren nach Anspruch 13, bei dem der Novolak das Produkt einer Kresol-Formaldehyd-Kondensation ist.

**15.** Verfahren nach einem der Ansprüche 1 bis 12, bei dem das säurehärtende Phenolharz ein Polyvinylphenol ist.

**16.** Verfahren nach Anspruch 15, bei dem das Polyvinylphenol ein teilweise gesättigtes Polyvinylphenol ist.

**17.** Verfahren nach einem der Ansprüche 1 bis 16, bei dem der Aminoplast ein alkoxyliertes Melamin ist.

**18.** Verfahren nach einem der Ansprüche 1 bis 16, bei dem der Aminoplast ein alkoxyliertes Melamin-Formaldehyd-Harz ist.

**19.** Verfahren nach einem der Ansprüche 17, bei dem das alkoxylierte Melamin Hexamethoxymethylmelamin ist.

**20.** Verfahren nach einem der Ansprüche 1 bis 19, bei dem die unter Lichteinwirkung Säure bildende Verbindung ausgewählt wird aus der Gruppe, bestehend aus 1,1-bis[p-Chlorphenyl]2,2,2-trichloräthan (DDT); 1,1-bis[p-Methoxyphenyl]2,2,2-trichloräthan (methoxychlor®); 1,2,5,6,9,10-Haxabromcyclododekan; 1,10-Dibromdekan; 1,1-bis[p-Chlorphenyl]2,2-dichloräthan; 4,4'-Dichlor-2-(trichlormethyl)benzhydrol oder 1,1-bis(Chlorphenyl)-2,2,2-trichloräthanol (Keltane®); Hexachlordimethylsulfon; 2-Chlor-6-(trichlormethyl)pyridin; O,O-Diäthyl-O-(3,5,6-trichlor-2-pyridyl)phosphorthioat (Dursban®); 1,2,3,4,5,6-Hexachlorcyclohexan; N(1,1-bis[p-Chlorphenyl]-2,2,2-trichloräthylacetamid, tris[2,3-Dibrompropyl]-isocyanurat; 2,2-bis-[p-Chlorphenyl]-1,1-dichloräthylen.

**21.** Verfahren nach Anspruch 20, bei dem die unter Lichteinwirkung Säure bildende Verbindung tris[2,3-Dibrompropyl] isocyanurat ist.

**Revendications**

**1.** Procédé pour former une image de photorésist, ledit procédé comprenant les étapes consistant à :

(a) prendre une solution de photorésist comprenant un mélange dissous dans un solvant d'une résine phénolique durcissant par un acide, d'un agent réticulant de type aminoplaste éthérifié ayant au moins un groupe alcoxy par molécule dans une quantité suffisante pour fournir une image latente développable après exposition et d'un générateur de photoacide capable de libérer un acide lors d'une exposition à une énergie d'activation ;

(b) appliquer en revêtement ledit photorésist sur un substrat et sécher de façon substantielle le revêtement ainsi formé ;

11

(c) exposer le revêtement séché à un rayonnement d'activation à motifs ;

(d) faire durcir le photorésist exposé à une température de durcissement variant entre environ 70 et 160°C pendant un laps de temps suffisant pour faire durcir le photorésist ; et

(e) développer le photorésist avec un développeur ;

caractérisé par le fait qu'un contrôle du rapport molaire des groupes hydroxyle substitués sur le cycle sur la résine phénolique aux groupes éther de l'agent réticulant de type aminoplaste ("rapport chi") à l'intérieur d'une plage allant de 1,0 à 20,0 est utilisé pour conférer de façon sélective audit photorésist des propriétés désirées comprenant une absorption optique, une vitesse de dissolution, une photovitesse, un contraste, une résolution et un angle de paroi latérale améliorés.

2. Procédé selon la revendication 1, dans lequel la composition de photorésist absorbe de façon minimale un rayonnement d'activation et est appropriée pour la formation d'une image de photorésist ayant une épaisseur séchée d'au moins 0,5 micron, ledit rapport des moles de groupes hydroxyle substitués sur le cycle sur la résine phénolique aux groupes alcoxy de l'aminoplaste se situant entre 6,0 et 18,0, et le photorésist est appliqué en revêtement sur le substrat dans une épaisseur telle que, lors du séchage de celui-ci, l'épaisseur de revêtement sec dépasse 0,5 micron.

3. Procédé selon la revendication 2, dans lequel ledit rapport est entre 6,0 et 12,0.

4. Procédé selon la revendication 1, dans lequel la réflexion du rayonnement d'activation à partir d'une surface sur laquelle le photorésist est appliqué en revêtement est réduite, ledit rapport des moles de groupes hydroxyle substitués sur le cycle sur la résine phénolique aux groupes alcoxy de l'aminoplaste se situant entre 2,0 et 6,0.

5. Procédé selon la revendication 4, dans lequel ledit rapport est entre 2,0 et 4,0.

6. Procédé selon la revendication 1, dans lequel la vitesse de dissolution du photorésist non exposé à partir d'une surface sur laquelle le photorésist est appliqué en revêtement est augmentée, ledit rapport des moles de groupes hydroxyle substitués sur le cycle sur la résine phénolique aux groupes alcoxy de l'aminoplaste se situant entre 1,0 et 8,0 et ladite température de durcissement varie entre environ 90 et 150°C.

7. Procédé selon la revendication 6, dans lequel ledit rapport est entre 1,5 et 5,0.

8. Procédé selon la revendication 1, dans lequel la photovitesse est augmentée, ledit rapport des moles de groupes hydroxyle substitués sur le cycle sur la résine phénolique aux groupes alcoxy de l'aminoplaste se situant entre 2 et 9, et ladite température de durcissement varie entre environ 110° et 140°C.

9. Procédé selon la revendication 8, dans lequel ledit rapport est entre 4 et 7.

10. Procédé selon la revendication 1, dans lequel une image de photorésist à contraste élevé est formée, ledit rapport des moles de groupes hydroxyle substitués sur le cycle sur la résine phénolique aux groupes alcoxy de l'aminoplaste se situant entre 1 et 9, et ladite température de durcissement varie entre environ 110° et 140°C.

11. Procédé selon la revendication 1, dans lequel une image de photorésist à contraste élevé est formée alors que le coefficient de diffusion de l'acide photogénéré à travers l'interface résist/air et à travers l'interface résist non exposé/exposé est réduit, ledit rapport des moles de groupes hydroxyle substitués sur le cycle sur la résine phénolique aux groupes alcoxy de l'aminoplaste se situant entre 1,0 et 8,0, et ladite température de durcissement varie entre environ 70° et 160°C.

12. Procédé selon la revendication 11, dans lequel ledit rapport est entre 1,0 et 3,0.

13. Procédé selon l'une quelconque des revendications 1 à 12, dans lequel ladite résine phénolique durcissant par un acide est une novolaque.

14. Procédé selon la revendication 13, dans lequel ladite novolaque est le produit d'une condensation crésol formaldéhyde.

**15.** Procédé selon l'une quelconque des revendications 1 à 12, dans lequel ladite résine phénolique durcissant par un acide est un polyvinylphénol.

**16.** Procédé selon la revendication 15, dans lequel ledit polyvinylphénol est un polyvinylphénol partiellement saturé.

**17.** Procédé selon l'une quelconque des revendications 1 à 16, dans lequel ledit aminoplaste est une mélamine alcoxylée.

**18.** Procédé selon l'une quelconque des revendications 1 à 16, dans lequel ledit aminoplaste est une résine mélamine alcoxylée formaldéhyde.

**19.** Procédé selon la revendication 17, dans lequel ladite mélamine alcoxylée est l'hexaméthoxyméthylmélamine.

**20.** Procédé selon l'une quelconque des revendications 1 à 19, dans lequel ledit générateur de photoacide est choisi dans le groupe constitué par :

- le 1,1-bis[p-chlorophényl]2,2,2-trichloroéthane (DDT)
- le 1,1-bis[p-méthoxyphényl]2,2,2-trichloroéthane (méthoxychlor®) ;
- le 1,2,5, 6,9,10-hexabromocyclododécane ;
- le 1,10-dibromodécane ;
- le 1,1-bis[p-chlorophényl]2,2,-dichloroéthane ;
- le 4,4'-dichloro-2-(trichlorométhyl)benzhydrol ou 1,1-bis(chlorophényl)2,2,2-trichloroéthanol (Keltane®) ;
- l'hexachlorodiméthylsulfone ;
- la 2-chloro-6-(trichlorométhyl)pyridine ;
- l'O,O-diéthyl-O-(3,5,6-trichloro-2-pyridyl)phosphorothioate (Dursban®) ;
- le 1,2,3,4,5,6-hexachlorocyclohexane;
- le N-(l,l-bis[p-chlorophényl]-2,2,2-trichloroéthylacétamide ;
- le tris[2,3-dibromopropyl]-isocyanurate ;
- le 2,2-bis[p-chlorophényl]-1,1-dichloroéthylène.

**21.** Procédé selon la revendication 20, dans lequel ledit générateur de photoacide est le tris[2,3-dibromopropyl]isocyanurate.

FIG. 1

FIG. 2

FIG.3

FIG. 4

# FIG. 5

# FIG. 6

# FIG. 7

# FIG. 8

# FIG. 9